# EUROPEAN PATENT SPECIFICATION

(11) **EP 4 152 097 B1**
(45) Date of publication and mention of the grant of the patent: **01.01.2025**
(21) Application number: 21804523.5
(22) Date of filing: 09.03.2021
(51) Int. Cl.: H05G 2/00

(54) **EXTREME ULTRAVIOLET LIGHT SOURCE DEVICE**
LICHTQUELLENVORRICHTUNG FÜR EXTREME UV-STRAHLUNG
DISPOSITIF SOURCE DE LUMIÈRE ULTRAVIOLETTE EXTRÊME

(30) Priority: 15.05.2020 JP 2020086261
(43) Date of publication of application: 22.03.2023
(73) Proprietor: Ushio Denki Kabushiki Kaisha, Tokyo 100-8150 (JP)
(72) Inventor: URAKAMI, Hideyuki, Tokyo 100-8150 (JP); MORIMOTO, Shunichi, Tokyo 100-8150 (JP)
(74) Representative: Maiwald GmbH
(86) International application number: PCT/JP2021/009330
(87) International publication number: WO 2021/229902

(56) References cited:
- JP-A- 2007 505 460
- JP-A- 2008 204 940
- JP-A- 2011 507 206
- JP-A- H04 245 199

## Description

### TECHNICAL FIELD

The present invention relates to extreme ultraviolet light source apparatuses.

### BACKGROUND ART

Recently, due to increasing miniaturization and integration of semiconductor integrated circuits, shortening of a wavelength of an exposure light source has been promoted. As a next-generation light source for exposing semiconductors, an extreme ultraviolet light source apparatus (hereinafter also referred to as an "EUV light source apparatus") that emits extreme ultraviolet light (hereinafter also referred to as "EUV (extreme ultraviolet) light") having a wavelength of 13.5 nm has been developed.

There are several known methods for generating EUV light (EUV radiation) in an EUV light source apparatus. One method is to generate a high-temperature plasma by heating and exciting an extreme ultraviolet light radiation subject (hereinafter, also referred to as "EUV radiation subject"), and to generate EUV light emitted from the high-temperature plasma.

EUV light source apparatuses that employ such a method are classified into an LPP (Laser Produced Plasma) method and a DPP (Discharge Produced Plasma) method, depending on the generation scheme.

An EUV light source apparatus of the DPP type applies a high voltage to a gap between electrodes in which a discharge gas containing EUV radiation subject (plasma raw material in a gas phase) is supplied, to generate a high-density and high-temperature plasma by discharge, and utilizes extreme ultraviolet light radiated therefrom. As a specific DPP method as disclosed, for example, in Patent Document 1, a method is proposed in which a liquid high-temperature plasma raw material (for example, Sn (tin)) is supplied to surfaces of electrodes that generate a discharge, an energy beam such as a laser beam is directed to the raw material to vaporize the raw material, and a high-temperature plasma is generated by the discharge. Such an approach may be referred to as LDP (Laser Assisted Discharge Plasma).

In the technology disclosed in Patent Document 1, a pair of disk-shaped rotating electrodes are used to reduce a thermal load on the electrodes. The electrodes are arranged so that their peripheral edges are close to each other. Pulsed power for discharge is applied to the rotating electrodes at a fixed period (e.g., 4 kHz or higher), so that a plasma that emits extreme ultraviolet light is generated at the fixed period.

### BACKGROUND DOCUMENT(S)

### PATENT DOCUMENT(S)

Patent Document 1: JP-A-2017-103120
Patent Document 2: JP 2011 507206 A

### SUMMARY OF INVENTION

### PROBLEM TO BE SOLVED BY THE INVENTION

To generate plasma in an energy efficient manner (i.e., to reduce loss of energy needed for plasma generation), it is desirable to make the rise of the discharge current between both the rotating electrodes faster.

Accordingly, it is an object of the present invention to provide an extreme ultraviolet light source apparatus that can enable faster rising of discharge current.

### MEANS FOR SOLVING THE PROBLEMS

In accordance with the present invention, there is provided an extreme ultraviolet light source apparatus, including a disk-shaped cathode; a first rotational shaft made of a metal to which the cathode is connected; a disc-shaped anode disposed apart from the cathode; a second rotational shaft made of a metal to which the anode is connected; a first tin supplier configured to coat the cathode with liquid-phase tin; a second tin supplier configured to coat the anode with liquid-phase tin; an energy beam irradiation device configured to irradiate the tin on the cathode with an energy beam to vaporize the tin and generate gas-phase tin in a gap between the cathode and the anode; an electric power supply configured to supply electric power to the cathode and anode to cause a discharge between the cathode and anode for generating a plasma in the gap between the cathode and anode, the plasma emitting extreme ultraviolet light; a first support structure made of a metal supporting the cathode; and a second support structure made of a metal supporting the anode. The first support structure and the second support structure are not in contact with each other. The first support structure has a first support wall portion and a first tubular portion protruding from the first support wall portion and surrounding the first rotational shaft, and the first tubular portion is disposed between the first support wall portion and the cathode. The second support structure has a second support wall portion and a second tubular portion protruding from the second support wall portion and surrounding the second rotational shaft, and the second tubular portion is disposed between the second support wall portion and the anode. The first support wall portion and the second support wall portion overlap each other. The first support wall portion has a through-hole through which the second tubular portion is inserted, or the second support wall portion has a through-hole through which the first tubular portion is inserted.

In this aspect, the rise of the discharge current that flows between the cathode and anode can be made faster. This reduces loss of the energy needed for plasma generation and increases the luminance of the extreme ultraviolet light generated. The reason for faster occurrence of the rise of the discharge current is not certain, but can be estimated as follows: The first and second support structures made of metal that respectively support the cathode and the anode constitute a discharge circuit that causes a discharge between the cathode and the anode. In this aspect, the first support wall portion of the first support structure and the second support wall portion of the second support structure overlap each other, and a tubular portion of a support structure is inserted into a through-hole in the support wall portion of the other support structure. This allows the first and second support structures made of metal, in particular the first and second support wall portions to be disposed extremely close to each other. In this way, two objects in which current flows in opposite directions are placed very close to each other, so that the magnetomotive forces of the first support structure and the second support structure cancel each other out. Accordingly, it is estimated that the inductance of the entire discharge circuit can be reduced and that the rise of the discharge current can be made faster.

Preferably, the first support structure has outer wall portions protruding from the first support wall portion and facing outer surfaces of the second support wall portion.

In this case, the magnetomotive forces of the first and second support structures further cancel each other out since adjacent portions of the first and second support structures are increased.

Preferably, the second support structure has outer wall portions protruding from the second support wall portion and facing outer surfaces of the first support wall portion.

In this case, the magnetomotive forces of the first and second support structures further cancel each other out since adjacent portions of the first and second support structures are increased.

Preferably, insulators are disposed between the first support structure and the second support structure.

In this case, the first and second support structures are insulated from each other and the spacing therebetween is properly maintained.

Preferably, the extreme ultraviolet light source apparatus further includes a support base member made of a metal for supporting the first support structure and the second support structure, and at least one of a gap between the support base member and the first support structure and a gap between the support base member and the second support structure is closed with a capacitor.

In this case, the capacitor is arranged around the discharge circuit, the inductance of the entire discharge circuit can be further reduced.

### EFFECT OF THE INVENTION

In accordance with an aspect of the present invention, the rise of discharge current can be made faster.

### BRIEF DESCRIPTION OF THE DRAWINGS

FIG. 1 is a schematic view of an extreme ultraviolet light source apparatus according to an embodiment of the present invention, showing a cross section of a first support structure that supports a cathode and a second support structure that supports an anode;
FIG. 2 is a perspective view showing the cathode, the first support structure, the anode, and the second support structure of the extreme ultraviolet light source apparatus;
FIG. 3 is a perspective view of the cathode and first support structure;
FIG. 4 is a perspective view of the anode and second support structure;
FIG. 5 is a schematic view of an extreme ultraviolet light source apparatus according to a comparison example;
FIG. 6 is a graph showing a current waveform during discharge that occurs between the rotating electrodes in the extreme ultraviolet light source apparatus according to the embodiment;
FIG. 7 is a graph showing a current waveform during discharge that occurs between the rotating electrodes in the extreme ultraviolet light source apparatus according to the comparison example;
FIG. 8 is a schematic view of an extreme ultraviolet light source apparatus according to another embodiment of the present invention, showing a cross section of a first support structure that supports a cathode and a second support structure that supports an anode;
FIG. 9 is a schematic view of an extreme ultraviolet light source apparatus according to another embodiment of the present invention, showing a cross section of a first support structure that supports a cathode and a second support structure that supports an anode; and
FIG. 10 is a schematic view of an extreme ultraviolet light source apparatus according to another embodiment of the present invention, showing a cross section of a first support structure that supports a cathode and a second support structure that supports an anode.

### EMBODIMENTS OF THE INVENTION

Hereinafter, with reference to the accompanying drawings, various embodiments according to the present invention will be described. It is of note that the drawings are not necessarily to scale, and certain features may be exaggerated or omitted.

An extreme ultraviolet light source apparatus (EUV light source apparatus) 1 is an apparatus that is configured to emit extreme ultraviolet light (EUV light) having a wavelength of, for example, 13.5 nm, and that can be used as a light source apparatus of a lithography apparatus for manufacturing semiconductor devices or as a light source apparatus for an apparatus for inspecting masks used for lithography.

The EUV light source apparatus 1 according to the embodiment is an EUV light source apparatus of the DPP type. More specifically, the EUV light source apparatus uses an energy beam such as a laser beam to irradiate a plasma raw material in a liquid phase applied to the surfaces of the pair of electrodes to vaporize the plasma raw material, and an electric power source to supply electric power to the electrodes to cause a discharge and generate a high-temperature plasma between the electrodes. EUV light is emitted from the plasma.

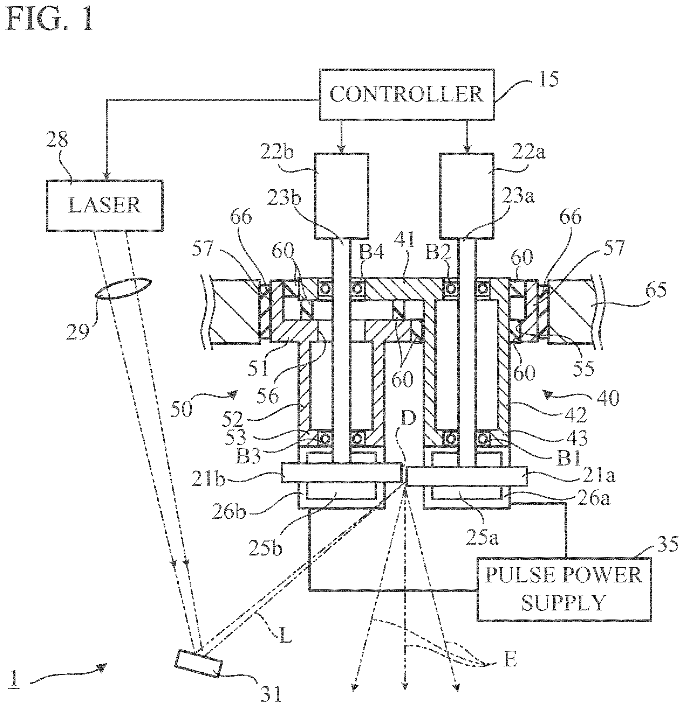

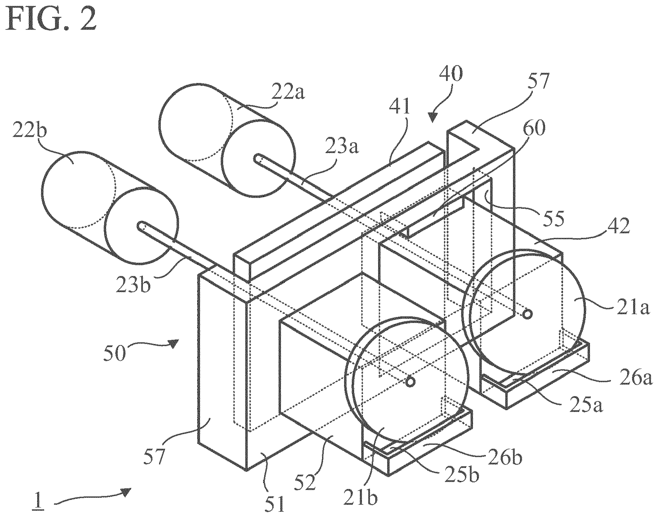

As shown in FIGS. 1 and 2, the EUV light source apparatus 1 has a pair of discharge electrodes 21a and 21b. The discharge electrodes 21a and 21b are each discs of the same shape and the same size; the discharge electrode 21a is used as a cathode, whereas the discharge electrode 21b is used as an anode. The discharge electrodes 21a and 21b are formed of, for example, a high melting point metal, such as tungsten, molybdenum, or tantalum.

The discharge electrodes 21a and 21b are disposed at positions spaced apart from each other, but the peripheral portions of the discharge electrodes 21a and 21b are close to each other. At a position in which the peripheral portion of the cathode 21a and the peripheral portion of the anode 21b are closest, a discharge occurs in the gap between the cathode 21a and the anode 21b, and a high-temperature plasma is generated. Hereinafter, the gap between the cathode 21a and the anode 21b at the position in which the peripheral portion of the cathode 21a and the peripheral portion of the anode 21b are closest is referred to as a "discharge region D".

The cathode 21a is connected to the rotational shaft (first rotational shaft) 23a of the motor 22a and rotates about the axis of the cathode 21a. The anode 21b is connected to the rotational shaft (second rotational shaft) 23b of the motor 22b and rotates about the axis of the anode 21b. Thus, the discharge electrodes 21a and 21b are respectively driven by separate motors 22a and 22b. The rotational shafts 23a and 23b of the motors 22a and 22b are made of metal.

The rotation of each of the motors 22a and 22b is controlled by a controller 15.

The EUV light source apparatus 1 includes a tin reservoir 26a for storing liquid-phase tin 25a, which is a plasma raw material, and a tin reservoir 26b for storing liquid-phase tin 25b. Heated liquid-phase tin 25a and 25b is supplied to the tin reservoirs 26a, 26b.

A lower part of the cathode 21a is immersed in tin 25 in the tin reservoir 26a, and a lower part of anode 21b is immersed in tin 25b in the tin reservoir 26b. As a result, liquid-phase tin (Sn), which is the plasma raw material, adheres to the discharge electrodes 21a and 21b. As the discharge electrodes 21a and 21b rotate, the liquid-phase tin 25a and 25b is transported to the discharge region D at which the high-temperature plasma is to be generated.

Accordingly, the tin reservoir 26a alone or the combination of the tin reservoir 26a and the motor 22a serves as a first tin supplier for coating the cathode 21a with the plasma raw material in a liquid phase. Similarly, the tin reservoir 26b alone or the combination of the tin reservoir 26b and the motor 22b serves as a second tin supplier for coating the anode 21b with the plasma raw material in a liquid phase. However, the material supplier is not limited to the type of this embodiment, and may be of other types.

The EUV light source apparatus 1 includes a laser (energy beam irradiation device) 28 that irradiates tin 25a coated on the cathode 21a with an energy beam to vaporize tin 25a. The laser 28 is, for example, Nd:YVO₄ laser (Neodymium-doped Yttrium Orthovanadate laser), and emits an infrared laser beam L. However, the energy beam irradiation device may be another device that emits a beam other than a laser beam capable of vaporizing tin 25a.

Illumination timing of the laser beam by the laser 28 is controlled by the controller 15.

The infrared laser beam L emitted from the laser 28 is directed to a movable mirror 31. Between the laser 28 and the movable mirror 31, typically a light-collecting means is disposed. The light-collecting means includes, for example, a condensing lens 29.

The infrared laser beam L is reflected by the movable mirror 31 and illuminates the outer peripheral surface of the cathode 21a in the vicinity of the discharge region D.

The infrared laser beam L reflected by the movable mirror 31 travels from the side of the anode 21b toward the cathode 21a, passes near the outer peripheral surface of the anode 21b, and then reaches the outer peripheral surface of the cathode 21a. The anode 21b is retracted behind the cathode 21a toward the upper side of Fig. 1 so as not to interfere with the progress of the infrared laser beam L.

The liquid phase tin 25a on the outer peripheral surface of the cathode 21a in the vicinity of the discharge region D is vaporized by irradiation with the infrared laser beam L, and a gas-phase plasma raw material is generated in the discharge region D.

To generate a high-temperature plasma in the discharge region D (to transform the plasma raw material in a gas phase to a plasma), a pulse power supply (electric power supply) 35 supplies electric power to the cathode 21a and the anode 21b, to cause a discharge between the cathode 21a and the anode 21b. The pulse power supply 35 periodically supplies pulsed electric power to the discharge electrodes 21a and 21b.

In this embodiment, the two electric supply lines extending from the pulse power supply 35 are connected to the tin reservoirs 26a and 26b, respectively. The tin reservoirs 26a and 26b are made of an electric conductive material, and tin 25a and 25b inside the tin reservoirs 26a and 26b is an electric conductive material, i.e., tin. The discharge electrodes 21a and 21b are immersed in tin 25a and 25b inside the tin reservoirs 26a and 26b. Thus, when the pulse power supply 35 supplies pulsed electric power to the tin reservoirs 26a and 26b, the pulsed electric power is consequently supplied to the discharge electrodes 21a and 21b.

When discharge occurs between the cathode 21a and the anode 21b, the plasma raw material in a gas phase in the discharge region D is heated and excited by a large current, so that a high-temperature plasma is generated. In addition, due to the high heat generated, tin 25b on the outer peripheral surface of the anode 21b in the vicinity of the discharge region D is also converted into plasma.

EUV light E is emitted from the high temperature plasma. EUV light E is used in other optical apparatus (a lithography apparatus or an inspection apparatus for masks).

The pulse power supply 35 applies pulsed power to the discharge electrodes 21a and 21b at a fixed period (e.g., 4 kHz or higher), so that a plasma that emits the EUV light E is generated at the fixed period.

Next, support structures that support the discharge electrodes 21a and 21b and the rotational shafts 23a and 23b will be described in detail.

The EUV light source apparatus 1 has a first support structure 40 made of a metal that supports the cathode 21a and a second support structure 50 made of a metal that supports the anode 21b. The first support structure 40 and the second support structure 50 are not in contact with each other and are insulated by a plurality of insulators 60, which are interposed therebetween.

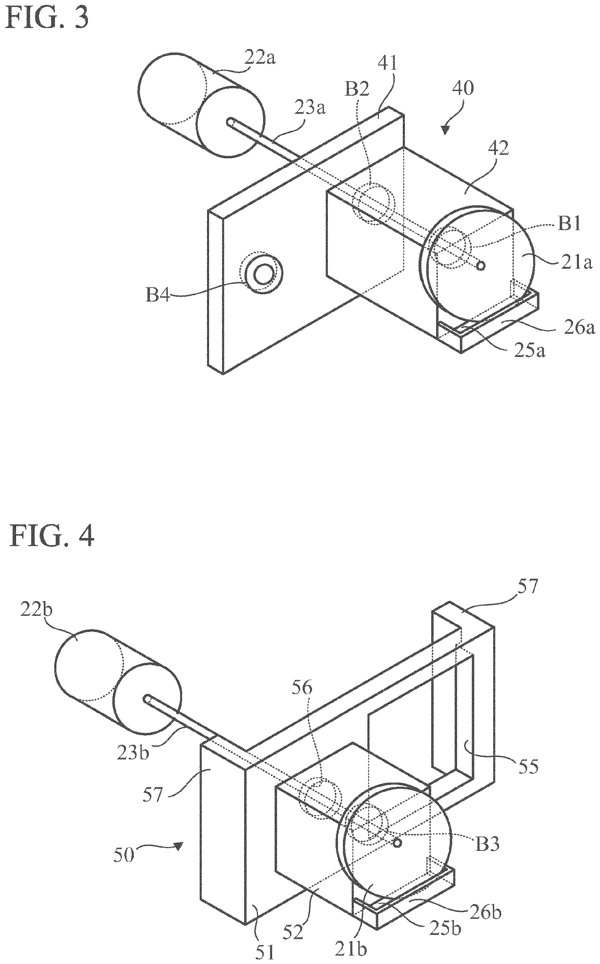

As shown in FIGS. 1 to 3, the first support structure 40 includes a first support wall portion 41 and a first tubular portion 42 that protrudes from the first support wall portion 41 and surrounds the first rotational shaft 23a. The first tubular portion 42 is disposed between the first support wall portion 41 and the cathode 21a.

In this embodiment, the first support wall portion 41 is a rectangular flat plate. However, the contour of the first support wall portion 41 does not need to be rectangular. In this embodiment, the first tubular portion 42 has the shape of a hollow square pipe. However, the first tubular portion 42 may have a shape of a cylinder or other tubular shape. In this embodiment, the first tubular portion 42 completely surrounds the rotational shaft 23a, but the first tubular portion 42 may have a hole or notch formed therein.

At the end of the first tubular portion 42 opposite to the first support wall portion 41, an end wall 43 is provided on which a bearing B1 is mounted. The bearing B1 supports the rotational shaft 23a to which the cathode 21a is fixed. Although not shown, sealing members are provided around the bearing B1 to keep the discharge region D in vacuum. The end wall 43 is also used as a wall of the tin reservoir 26a.

As shown in FIGS. 1, 2, and 4, the second support structure 50 includes a second support wall portion 51 and a second tubular portion 52 that protrudes from the second support wall portion 51 and surrounds the rotational shaft 23b. The second tubular portion 52 is disposed between the second support wall portion 51 and the anode 21b.

In this embodiment, the second support wall portion 51 is a rectangular flat plate. However, the contour of the second supportwall portion 51 does not need to be rectangular. In this embodiment, the second tubular portion 52 has the shape of a hollow square pipe. However, the second tubular portion 52 may have a shape of a cylinder or other tubular shape. In this embodiment, the second tubular portion 52 completely surrounds the rotational shaft 23b, but the second tubular portion 52 may have a hole or notch formed therein.

At the end of the second tubular portion 52 opposite to the second support wall portion 51, an end wall 53 is provided on which a bearing B3 is mounted. The bearing B3 supports the rotational shaft 23b to which the anode 21b is fixed. Although not shown, sealing members are provided around the bearing B3 to keep the discharge region D in vacuum. The end wall 53 is also used as a wall of the tin reservoir 26b.

The first support wall portion 41 and the second support wall portion 51 overlap each other. In this embodiment, the second support wall portion 51 is positioned closer to the discharge electrodes 21a and 21b than the first support wall portion 41, and a through-hole 55 is formed in the second support wall portion 51 through which the first tubular portion 42 is inserted. In this embodiment, the first tubular portion 42 and the second tubular portion 52 are arranged approximately parallel to each other, and the rotational shafts 23a and 23b are also arranged approximately parallel to each other.

The rotational shaft 23a of the motor 22a fixed to the cathode 21a is supported by the bearing B1 located in the end wall 43 of the first tubular portion 42 of the first support structure 40 and another bearing B2 located in the first support wall portion 41 of the first support structure 40.

The rotational shaft 23b of the motor 22b fixed to the anode 21b is supported by the bearing B3 located in the end wall 53 of the second tubular portion 52 of the second support structure 50 and another bearing B4 located in the first support wall portion 41 of the first support structure 40. The second support wall portion 51 of the second support structure 50 has a through-hole 56 through which the rotational shaft 23b passes. Instead of or in addition to the bearing B4 disposed in the first support wall portion 41, another bearing may be disposed in the through-hole 56 for supporting the rotational shaft 23b.

In this embodiment, the second support structure 50 has two outer wall portions 57 that protrude from the second support wall portion 51 and face outer surfaces of the first support wall portion 41. The two outer wall portions 57 are disposed on two sides of the second support wall portion 51 and face the two side surfaces of the first support wall portion 41. However, the outer wall portions 57 may be disposed on the top and bottom of the second support wall portion 51 and may face the top and bottom surfaces of the first support wall portion 41. The outer wall portions 57 may surround the first support wall portion 41 all around.

The EUV light source apparatus 1 further has a support base member 65 made of a metal for supporting the first support structure 40 and the second support structure 50. A gap between the support base member 65 and the first support structure 40 and a gap between the support base member 65 and the second support structure 50 are closed with capacitors 66.

The support base member 65 is part of the chamber (housing) of the EUV light source apparatus 1. The chamber is formed of a rigid material such as a metal. The discharge electrodes 21a and 21b, the tin reservoirs 26a and 26b, and the tubular portions 42 and 52 are located within the chamber. The interior of the chamber 11 is evacuated to reduce the attenuation of the EUV light E. As described above, sealing members (not shown) are provided around the bearings B1 and B3 to maintain the discharge region D in vacuum.

The inventors conducted an experiment to investigate the rise of discharge current in the EUV light source apparatus 1 according to the embodiment.

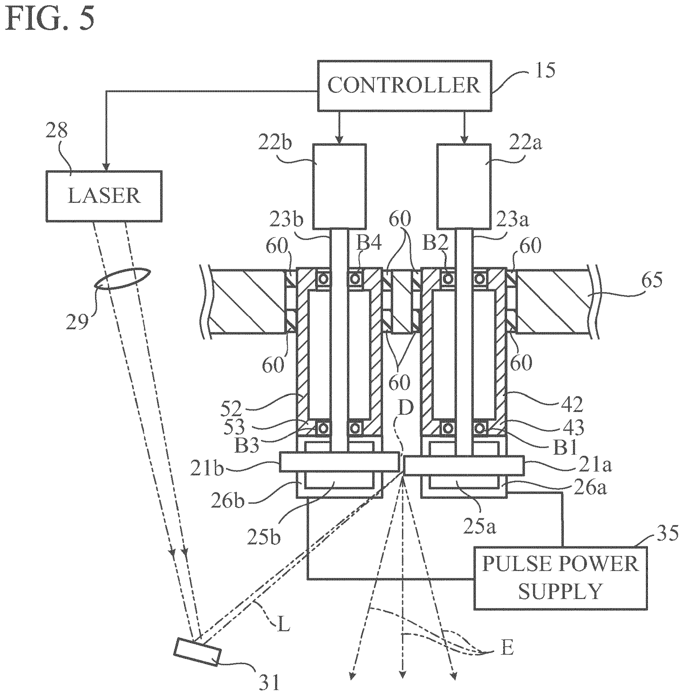

FIG. 5 is a schematic view of an EUV light source device used as a comparison example. In the comparison example shown in FIG. 5, the rotational shaft 23a fixed to the cathode 21a is surrounded by the first tubular portion 42 made of a metal, and the rotational shaft 23b fixed to the anode 21b is surrounded by the second tubular portion 52 made of a metal. However, in this comparison example, there is no equivalent corresponding to the first support wall portion 41, and there is no equivalent corresponding to the second support wall portion 51. The rotational shaft 23a of the motor 22a fixed to the cathode 21a is supported by the bearing B1 located in one end wall 43 of the first tubular portion 42 and another bearing B2 located in the other end wall of the first tubular portion 42. The rotational shaft 23b of the motor 22b fixed to the anode 21b is supported by the bearing B3 located in one end wall 53 of the second tubular portion 52 and another bearing B4 located in the other end wall of the second tubular portion 52. The first tubular section 42 and the second tubular section 52 are supported by the support base member 65. The first and second tubular portions 42 and 52 and the support base member 65 are not in contact with each other and are insulated by multiple insulators 60.

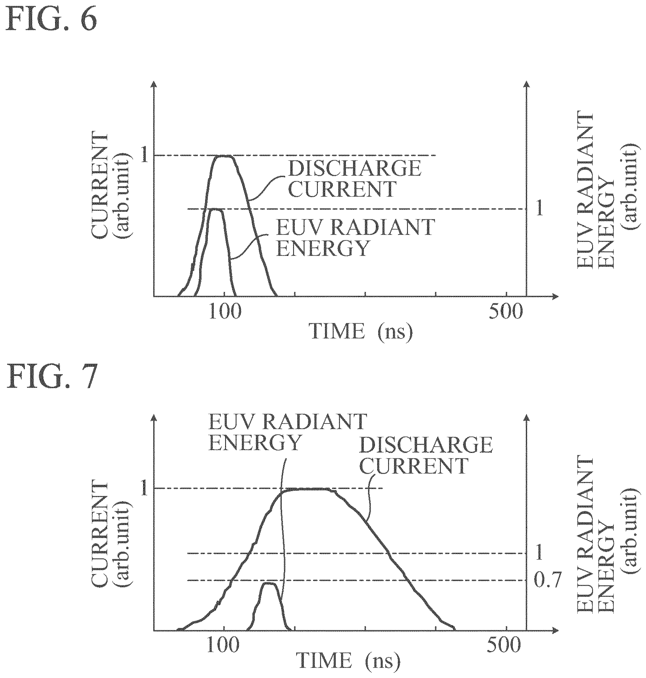

FIG. 6 is a graph showing a current waveform during the discharge that occurs between the discharge electrodes 21a and 21b and showing change in radiant energy of the EUV light E in the EUV light source apparatus 1 according to the embodiment. Fig. 7 is a graph showing a current waveform during the discharge that occurs between the discharge electrodes 21a and 21b and showing change in radiant energy of the EUV light E in the EUV light source apparatus 1 according to the comparison example shown in FIG. 5.

As is clear from Figs. 6 and 7, the rise of the discharge current that flowed between the cathode 21a and the anode 21b can be faster in the embodiment than in the comparison example. As a result, there is less loss of energy needed for plasma generation in the embodiment, so that the luminance of the generated EUV light E can be enhanced.

The reason for faster occurrence of the rise of the discharge current by the embodiment is not certain, but can be estimated as follows: The first and second support structures 40 and 50 made of metal that respectively support the cathode 21a and the anode 21b constitute a discharge circuit that causes a discharge between the cathode 21a and the anode 21b. The rotational shafts 23a and 23b, to which the discharge electrodes 21a and 21b are connected, and the bearings B1 to B4, which are in contact with the rotational shafts 23a and 23b, are also made of metal and constitute the discharge circuit.

The first support wall portion 41 of the first support structure 40 and the second support wall portion 51 of the second support structure 50 overlap each other, and the first tubular portion 42 of the first support structure 40 is inserted into the through-hole 55 of the second support wall portion 51 of the second support structure 50. This allows that the first support structure 40 and the second support structure 50 made of metal, in particular the first support wall portion 41 and the second support wall portion 51 to be disposed extremely close to each other. In this way, two objects in which current flows in opposite directions are placed very close to each other, so that the magnetomotive forces of the first support structure 40 and the second support structure 50 cancel each other out. Accordingly, it is estimated that the inductance of the entire discharge circuit can be reduced and that the rise of the discharge current can be made faster.

In addition, in this embodiment, the second support structure 50 has outer wall portions 57 that protrude from the second support wall portion 51 and that face outer surfaces of the first support wall portion 41. Thus, adjacent portions of the first support structure 40 and the second support structure 50 are increased, so that the magnetomotive forces of the first support structure 40 and the second support structure 50 further cancel each other out, and the inductance of the entire discharge circuit is further reduced.

In this embodiment, the insulators 60 are interposed between the first support structure 40 and the second support structure 50. Thus, the first support structure 40 and the second support structure 50 are insulated from each other and the spacing therebetween is properly maintained.

In addition, in this embodiment, the first support structure 40 and the second support structure 50 are supported by the metal support base member 65, and a gap between the support base member 65 and the first support structure 40 and a gap between the support base member 65 and the second support structure 50 are closed with capacitors 66. In this way, since the capacitors 66 are arranged around the discharge circuit, the inductance of the entire discharge circuit can be further reduced.

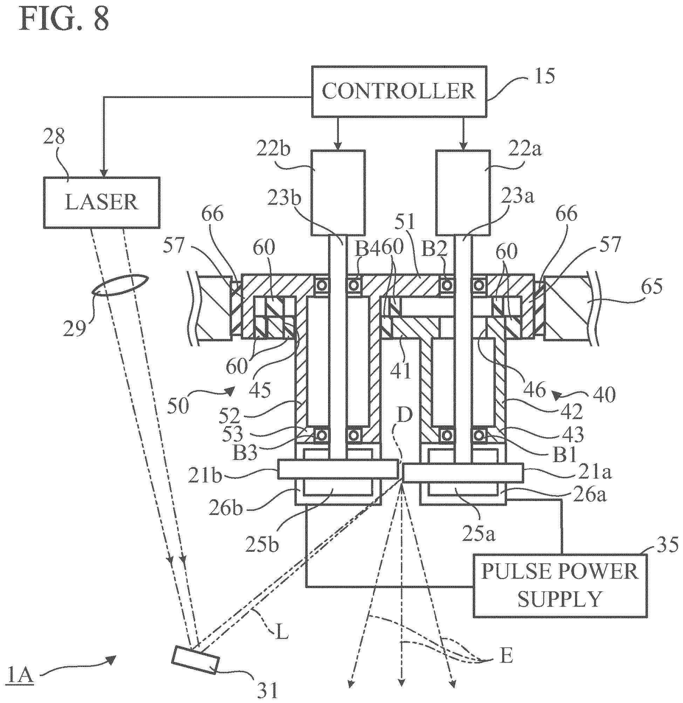

FIG. 8 shows an EUV light source apparatus 1A according to another embodiment of the present invention. In the EUV light source apparatus 1A, contrary to the EUV light source apparatus 1, the first support wall portion 41 is located closer to the discharge electrodes 21a and 21b than the second support wall portion 51, and a through-hole 45 is formed in the first support wall portion 41 for insertion of the second tubular portion 52.

In this embodiment, again, the first support wall portion 41 of the first support structure 40 and the second support structure 50 overlap each other, and the second tubular portion 52 of the second support structure 50 is inserted into the through-hole 45 of the first support wall portion 41 of the first support structure 40. This allows the first support structure 40 and the second support structure 50 made of metal, in particular the first support wall portion 41 and the second support wall portion 51 to be disposed extremely close to each other. It is estimated that in this way, two objects in which current flows in opposite directions are placed very close to each other, so that the magnetomotive forces of the first support structure 40 and the second support structure 50 cancel each other out.

In addition, in this embodiment, the second support structure 50 has outer wall portions 57 that protrude from the second support wall portion 51 and that face outer surfaces of the first support wall portion 41. Thus, adjacent portions of the first support structure 40 and the second support structure 50 are increased, so that the magnetomotive forces of the first support structure 40 and the second support structure 50 further cancel each other out, and the inductance of the entire discharge circuit is further reduced.

In this embodiment, the rotational shaft 23a of the motor 22a fixed to the cathode 21a is supported by the bearing B1 located in the end wall 43 of the first tubular portion 42 of the first support structure 40 and another bearing B2 located in the second support wall portion 51 of the second support structure 50. The first support wall portion 41 of the first support structure 40 has a through-hole 46 through which the rotational shaft 23a passes. Instead of or in addition to the bearing B2 disposed in the second support wall portion 51, another bearing may be disposed in the through-hole 46 for supporting the rotational shaft 23a.

The rotational shaft 23b of the motor 22b fixed to the anode 21b is supported by the bearing B3 located in the end wall 53 of the second tubular portion 52 of the second support structure 50 and another bearing B4 located in the second support wall portion 51 of the second support structure 50.

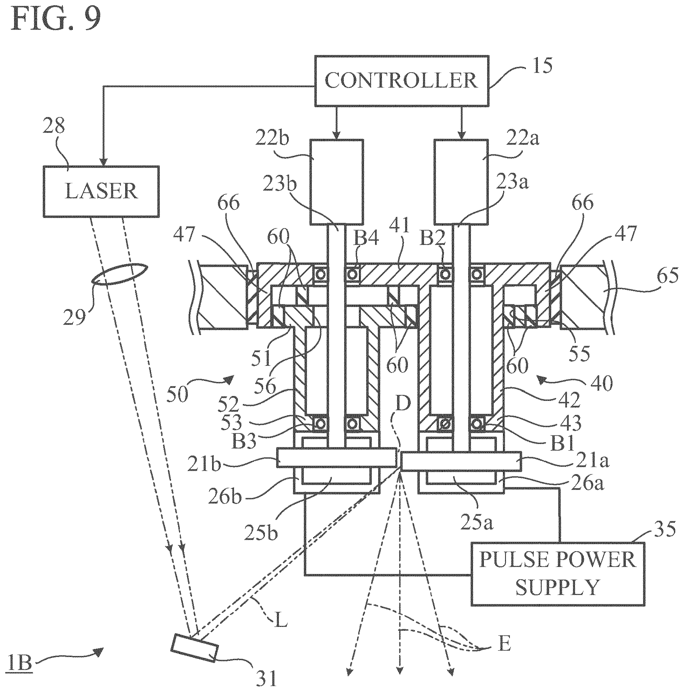

FIG. 9 shows an EUV light source apparatus 1B according to another embodiment of the present invention. In the EUV light source apparatus 1B, the first support structure 40 has two outer wall portions 47 that protrude from the first support wall portion 41 and that face outer surfaces of the second support wall portion 51. The two outer wall portions 47 are disposed on two sides of the first support wall portion 41 and face the two side surfaces of the second supportwall portion 51. However, the outer wall portions 57 may be disposed on the top and bottom of the first support wall portion 41 and may face the top and bottom surfaces of the second support wall portion 51. The outer wall portions 47 may surround the second support wall portion 51 all around.

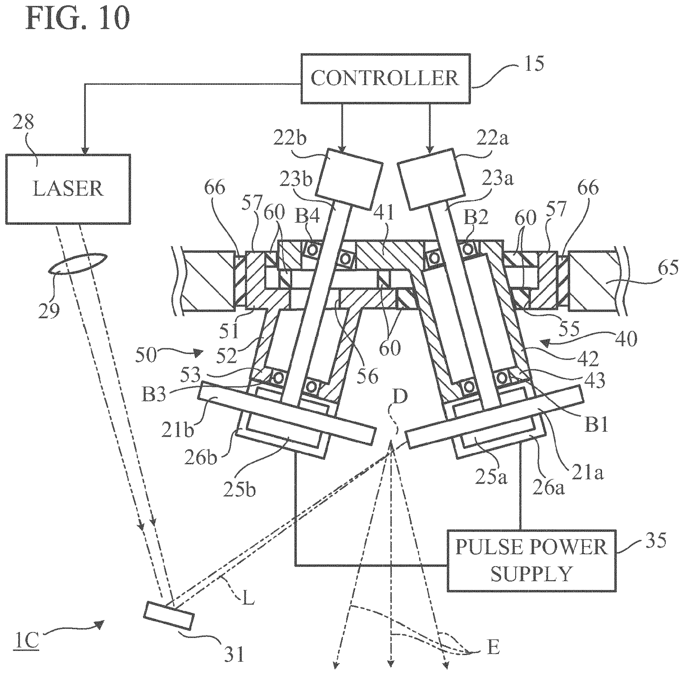

FIG. 10 shows an EUV light source apparatus 1C according to another embodiment of the present invention. In the EUV light source apparatus 1C, to facilitate irradiation of the outer peripheral surface of the cathode 21a with the infrared laser beam L, the axes of the discharge electrodes 21a and 21b are not parallel. The spacing between the rotational shafts 23a and 23b is narrower on the side of the motors and wider on the side of the electrodes. Therefore, the first tubular portion 42 is inclined with respect to the first support wall portion 41, and the second tubular portion 52 is inclined with respect to the second support wall portion 51.

### Other Modifications

The present invention has been shown and described with reference to preferred embodiments thereof. However, it will be understood by those skilled in the art that various changes in form and detail may be made without departing from the scope of the invention as defined by the claims.

### REFERENCE SYMBOLS

1, 1A, 1B, 1C: Extreme ultraviolet light source apparatus (EUV light source device)
21a: Cathode
21b: Anode
22a: Motor (first tin supplier)
22b: Motor (second tin supplier)
23a: Rotational shaft (first rotational shaft)
23b: Rotational shaft (second rotational shaft)
26a: Tin reservoir (first tin supplier)
26b: Tin reservoir (second tin supplier)
28: Laser (energy beam irradiation device)
35: Pulse power supply (electric power supply)
40: First support structure
41: First support wall portion
42: First tubular portion
45: Through-hole
47: Outer wall portion
50: Second support structure
51: Second support wall portion
52: Second tubular portion
55: Through-hole
57: Outer wall portion
60: Insulator
65: Support base member
L: Infrared laser beam
P: Plasma
D: Discharge region
B1, B2, B3, B4: Bearing

## Claims

1. An extreme ultraviolet light source apparatus (1, 1A, 1B, 1C), comprising:
a disk-shaped cathode (21a);
a first rotational shaft (23a) made of a metal to which the cathode (21a) is connected;
a disc-shaped anode (21b) disposed apart from the cathode (21a);
a second rotational shaft (23b) made of a metal to which the anode (21b) is connected;
a first tin supplier (22a, 26a) configured to coat the cathode (21a) with liquid-phase tin (25a);
a second tin supplier (22b, 26b) configured to coat the anode (21b) with liquid-phase tin (25b);
an energy beam irradiation device (28) configured to irradiate the tin (25a) on the cathode (21a) with an energy beam to vaporize the tin (25a) and generate gas-phase tin in a gap between the cathode (21a) and the anode (21b);
an electric power supply (35) configured to supply electric power to the cathode (21a) and anode (21b) to cause a discharge between the cathode (21a) and anode (21b) for generating a plasma in the gap between the cathode (21a) and anode (21b), the plasma emitting extreme ultraviolet light;
a first support structure (40) made of a metal supporting the cathode (21a); and
a second support structure (50) made of a metal supporting the anode (21b),
the first support structure (40) and the second support structure (50) being not in contact with each other,
the first support structure (40) having a first support wall portion (41) and a first tubular portion (42) protruding from the first support wall portion (41) and surrounding the first rotational shaft (23a), the first tubular portion (42) being disposed between the first support wall portion (41) and the cathode (21a),
the second support structure (50) having a second support wall portion (51) and a second tubular portion (52) protruding from the second support wall portion (51) and surrounding the second rotational shaft (23b), the second tubular portion (52) being disposed between the second support wall portion (51) and the anode (21b),
the first support wall portion (41) and the second support wall portion (51) overlapping each other,
the first support wall portion (41) having a through-hole (45) through which the second tubular portion (52) is inserted, or the second support wall portion (51) having a through-hole (55) through which the first tubular portion (42) is inserted.

2. The extreme ultraviolet light source apparatus (1B) according to claim 1, wherein the first support structure (40) has outer wall portions (47) protruding from the first support wall portion (41) and facing outer surfaces of the second support wall portion (51).

3. The extreme ultraviolet light source apparatus (1, 1A, 1C) according to claim 1, wherein the second support structure (50) has outer wall portions (57) protruding from the second support wall portion (51) and facing outer surfaces of the first support wall portion (41).

4. The extreme ultraviolet light source apparatus (1, 1A, 1B, 1C) according to claim 1 or 2, wherein insulators (60) are disposed between the first support structure (40) and the second support structure (50).

5. The extreme ultraviolet light source apparatus (1, 1A, 1B, 1C) according to claim 1 or 2, further comprising a support base member (65) made of a metal for supporting the first support structure (40) and the second support structure (50),
at least one of a gap between the support base member (65) and the first support structure (40) and a gap between the support base member (65) and the second support structure (50) being closed with a capacitor (66).

## Patentansprüche

1. Extrem-Ultraviolett-Lichtquellenvorrichtung (1, 1A, 1B, 1C), umfassend:
eine scheibenförmige Kathode (21a),
eine erste Drehwelle (23a) aus einem Metall, mit der die Kathode (21a) verbunden ist,
eine scheibenförmige Anode (21b), die getrennt von der Kathode (21a) angeordnet ist,
eine zweite Drehwelle (23b) aus einem Metall, mit der die Anode (21b) verbunden ist,
einen ersten Zinnlieferanten (22a, 26a), der so konfiguriert ist, dass er die Kathode (21a) mit Zinn in flüssiger Phase (25a) beschichtet,
einen zweiten Zinnlieferanten (22b, 26b), der so konfiguriert ist, dass er die Anode (21b) mit Zinn in flüssiger Phase (25b) beschichtet,
eine Energiestrahl-Bestrahlungsvorrichtung (28), die so konfiguriert ist, dass sie das Zinn (25a) auf der Kathode (21a) mit einem Energiestrahl bestrahlt, um das Zinn (25a) zu verdampfen und Zinn in der Gasphase in einem Spalt zwischen der Kathode (21a) und der Anode (21b) zu erzeugen,
eine elektrische Stromversorgung (35), die so konfiguriert ist, dass sie der Kathode (21a) und der Anode (21b) elektrische Energie zuführt, um eine Entladung zwischen der Kathode (21a) und der Anode (21b) zu bewirken, um ein Plasma in dem Spalt zwischen der Kathode (21a) und der Anode (21b) zu erzeugen, wobei das Plasma Extremultraviolettlicht emittiert,
eine erste Trägerstruktur (40) aus einem Metall, die die Kathode (21a) trägt, und
eine zweite Trägerstruktur (50) aus einem Metall, die die Anode (21b) trägt,
wobei die erste Trägerstruktur (40) und die zweite Trägerstruktur (50) nicht miteinander in Kontakt stehen,
wobei die erste Stützstruktur (40) einen ersten Stützwandabschnitt (41) und einen ersten rohrförmigen Abschnitt (42) aufweist, der von dem ersten Stützwandabschnitt (41) vorsteht und die erste Drehwelle (23a) umgibt, wobei der erste rohrförmige Abschnitt (42) zwischen dem ersten Stützwandabschnitt (41) und der Kathode (21a) angeordnet ist,
wobei die zweite Stützstruktur (50) einen zweiten Stützwandabschnitt (51) und einen zweiten rohrförmigen Abschnitt (52) aufweist, der von dem zweiten Stützwandabschnitt (51) vorsteht und die zweite Drehwelle (23b) umgibt, wobei der zweite rohrförmige Abschnitt (52) zwischen dem zweiten Stützwandabschnitt (51) und der Anode (21b) angeordnet ist,
wobei der erste Stützwandabschnitt (41) und der zweite Stützwandabschnitt (51) einander überlappen,
wobei der erste Stützwandabschnitt (41) ein Durchgangsloch (45) aufweist, durch das der zweite rohrförmige Abschnitt (52) eingeführt ist, oder der zweite Stützwandabschnitt (51) ein Durchgangsloch (55) aufweist, durch das der erste rohrförmige Abschnitt (42) eingeführt ist.

2. Extrem-Ultraviolett-Lichtquellenvorrichtung (1B) nach Anspruch 1, wobei die erste Stützstruktur (40) äußere Wandabschnitte (47) aufweist, die von dem ersten Stützwandabschnitt (41) vorstehen und den äußeren Oberflächen des zweiten Stützwandabschnitts (51) zugewandt sind.

3. Extrem-Ultraviolett-Lichtquellenvorrichtung (1, 1A, 1C) nach Anspruch 1, wobei die zweite Stützstruktur (50) äußere Wandabschnitte (57) aufweist, die von dem zweiten Stützwandabschnitt (51) vorstehen und den äußeren Oberflächen des ersten Stützwandabschnitts (41) zugewandt sind.

4. Extrem-Ultraviolett-Lichtquellenvorrichtung (1, 1A, 1B, 1C) nach Anspruch 1 oder 2, wobei Isolatoren (60) zwischen der ersten Trägerstruktur (40) und der zweiten Trägerstruktur (50) angeordnet sind.

5. Extrem-Ultraviolett-Lichtquellenvorrichtung (1, 1A, 1B, 1C) nach Anspruch 1 oder 2, die weiter ein aus einem Metall hergestelltes Trägerbasisteil (65) zum Tragen der ersten Trägerstruktur (40) und der zweiten Trägerstruktur (50) umfasst,
wobei wenigstens ein Spalt zwischen dem Trägerbasisteil (65) und der ersten Stützstruktur (40) oder ein Spalt zwischen dem Trägerbasisteil (65) und der zweiten Stützstruktur (50) mit einem Kondensator (66) verschlossen ist.

## Revendications

1. Appareil source de lumière ultraviolette extrême (1, 1A, 1B, 1C), comprenant :
une cathode en forme de disque (21a) ;
un premier axe de rotation (23a) constitué d'un métal auquel la cathode (21a) est connectée ;
une anode en forme de disque (21b) disposée à distance de la cathode (21a) ;
un second axe de rotation (23b) constitué d'un métal auquel l'anode (21b) est connectée ;
un premier dispositif d'alimentation en étain (22a, 26a) configuré pour revêtir la cathode (21a) d'étain en phase liquide (25a) ;
un second dispositif d'alimentation en étain (22b, 26b) configuré pour revêtir l'anode (21b) d'étain en phase liquide (25b) ;
un dispositif d'irradiation par faisceau d'énergie (28) configuré pour irradier l'étain (25a) sur la cathode (21a) avec un faisceau d'énergie afin de vaporiser l'étain (25a) et de générer de l'étain en phase gazeuse dans un interstice entre la cathode (21a) et
l'anode (21b) ;
une alimentation électrique (35) configurée pour fournir de l'énergie électrique à la cathode (21a) et à l'anode (21b) pour entraîner une décharge entre la cathode (21a) et l'anode (21b) pour générer un plasma dans l'interstice entre la cathode (21a) et
l'anode (21b), le plasma émettant de la lumière ultraviolette extrême ;
une première structure de support (40) constituée d'un métal supportant la cathode (21a) ; et
une seconde structure de support (50) constituée d'un métal supportant l'anode (21b),
la première structure de support (40) et la seconde structure de support (50) n'étant pas en contact l'une avec l'autre ;
la première structure de support (40) ayant une première partie de paroi de support (41) et une première partie tubulaire (42) faisant saillie à partir de la première partie de paroi de support (41) et entourant le premier axe de rotation (23a), la première partie tubulaire (42) étant disposée entre la première partie de paroi de support (41) et la cathode (21a),
la seconde structure de support (50) ayant une seconde partie de paroi de support (51) et une seconde partie tubulaire (52) faisant saillie à partir de la seconde partie de paroi de support (51) et entourant le second axe de rotation (23b), la seconde partie tubulaire (52) étant disposée entre la seconde partie de paroi de support (51) et l'anode (21b),
la première partie de paroi de support (41) et la seconde partie de paroi de support (51) se chevauchant mutuellement,
la première partie de paroi de support (41) ayant un trou traversant (45) à travers lequel la seconde partie tubulaire (52) est insérée, ou la seconde partie de paroi de support (51) ayant un trou traversant (55) à travers lequel la première partie tubulaire (42) est insérée.

2. Appareil source de lumière ultraviolette extrême (1B) selon la revendication 1, dans lequel la première structure de support (40) a des parties de paroi extérieures (47) faisant saillie à partir de la première partie de paroi de support (41) et étant dirigée vers des surfaces extérieures de la seconde partie de paroi de support (51).

3. Appareil source de lumière ultraviolette extrême (1,1A, 1C) selon la revendication 1, dans lequel la seconde structure de support (50) a des parties de paroi extérieures (57) faisant saillie à partir de la seconde partie de paroi de support (51) et étant dirigée vers des surfaces extérieures de la première partie de paroi de support (41).

4. Appareil source de lumière ultraviolette extrême (1, 1A, 1B, 1C) selon la revendication 1 ou 2, dans lequel des isolants (60) sont disposés entre la première structure de support (40) et la seconde structure de support (50).

5. Appareil source de lumière ultraviolette extrême (1, 1A, 1B, 1C) selon la revendication 1 ou 2, comprenant en outre un élément de base de support (65) constitué d'un métal pour supporter la première structure de support (40) et la seconde structure de support (50), au moins un parmi un interstice entre l'élément de base de support (65) et la première structure de support (40) et un interstice entre l'élément de base de support (65) et la seconde structure de support (50) étant fermé avec un condensateur (66).
